# FASCICULE DE BREVET EUROPEEN

(11) **EP 3 830 535 B1**
(45) Date de publication et mention de la délivrance du brevet: **20.07.2022**
(21) Numéro de dépôt: 19761924.0
(22) Date de dépôt: 29.07.2019
(51) Int. Cl.: G01J 3/26, G01J 3/28, H01L 27/146, G01J 3/02

(54) **CAPTEUR D'IMAGERIE MULTISPECTRALE POURVU DE MOYENS DE LIMITATION DE LA DIAPHONIE**
MULTISPEKTRALER BILDSENSOR MIT MITTELN ZUR NEBENSPRECHBEGRENZUNG
MULTISPECTRAL IMAGING SENSOR PROVIDED WITH MEANS FOR LIMITING CROSSTALK

(30) Priorité: 30.07.2018 FR 1800822
(43) Date de publication de la demande: 09.06.2021
(73) Titulaire: Silios Technologies, 13790 Peynier (FR)
(72) Inventeur: TISSERAND, Stéphane, 13400 AUBAGNE (FR); ROUX, Laurent, 13013 MARSEILLE (FR); HUBERT, Marc, 13710 FUVEAU (FR); SAUGET, Vincent, 13100 AIX EN PROVENCE (FR)
(74) Mandataire: IP Trust
(86) Numéro de dépôt international: PCT/FR2019/051864
(87) Numéro de publication internationale: WO 2020/025888

(56) Documents cités:
- WO-A1-2017/187029
- US-A1- 2003 006 416
- TANG HENG-JING ET AL: "The novel dual-waveband SWIR InGaAs FPAs with monolithic integration filter microstructure", VISUAL COMMUNICATIONS AND IMAGE PROCESSING; 20-1-2004 - 20-1-2004; SAN JOSE,, vol. 8982, 7 mars 2014 (2014-03-07), pages 898229-898229, XP060034925, DOI: 10.1117/12.2042837 ISBN: 978-1-62841-730-2
- WANG XU-QUAN ET AL: "Integrated Linear Variable Filter/InGaAs Focal Plane Array Spectral Micro-module and Its Wavelength Calibration", ACTA PHOTONICA SINICA - GUANGZI XUEBAO., vol. 47, no. 5, 1 mai 2018 (2018-05-01), XP055644631, CN ISSN: 1004-4213, DOI: 10.3788/gzxb20184705.0530001
- TARA MARTIN ET AL: "640x512 InGaAs focal plane array camera for visible and SWIR imaging", PROCEEDINGS OF SPIE, vol. 5783, 31 mai 2005 (2005-05-31), pages 12-20, XP055644400, 1000 20th St. Bellingham WA 98225-6705 USA ISSN: 0277-786X, DOI: 10.1117/12.603406 ISBN: 978-1-5106-2687-4
- COHEN M J ET AL: "A thin film indium gallium arsenide focal plane array for visible and near infrared hyperspectral imaging", 1999 IEEE LEOS ANNUAL MEETING CONFERENCE PROCEEDINGS : LEOS '99 12TH ANNUAL MEETING, IEEE LASERS AND ELECTRO-OPTICS SOCIETY 1999 ANNUAL MEETING, 8 - 11 NOVEMBER, RENAISSANCE PARC FIFTY-FIVE HOTEL, SAN FRANCISCO, CA, IEEE SERVICE CENTER, PISCATAWAY, N, vol. 2, 8 novembre 1999 (1999-11-08), pages 744-745, XP010360932, DOI: 10.1109/LEOS.1999.811948 ISBN: 978-0-7803-5634-4
- BORA M. ONAT ET AL: "A solid-state hyperspectral imager for real-time standoff explosives detection using shortwave infrared imaging", PROCEEDINGS OF SPIE, vol. 7310, 30 avril 2009 (2009-04-30), page 731004, XP055171700, ISSN: 0277-786X, DOI: 10.1117/12.820798

## Description

La présente invention concerne un capteur d'imagerie multispectrale pourvu de moyens de limitation de la diaphonie.

L'analyse spectrométrique vise notamment la recherche de constituants chimiques entrant dans la composition d'un milieu solide, liquide ou gazeux. Il s'agit d'enregistrer le spectre d'absorption en réflexion ou en transmission de ce milieu. La lumière qui interagit avec celui-ci est absorbée dans certaines bandes de longueurs d'onde. Cette absorption sélective est une signature d'une partie ou de l'ensemble des constituants du milieu. La plage de longueurs d'onde du spectre à mesurer peut appartenir à l'ultra violet et/ou au rayonnement visible et/ou à l'infra rouge (proche, moyen, lointain).

Cette analyse se fait couramment au moyen d'un spectromètre.

Certains spectromètres utilisent au moins un filtre Fabry-Pérot.

Pour mémoire, un tel filtre est une lame à face parallèle d'un matériau (le plus souvent d'indice de réfraction faible tel que air, silice, ...) appelé membrane d'espacement (plus couramment « spacer » en terminologie anglo-saxonne), cette membrane figurant entre deux miroirs. Il est souvent réalisé par dépôt de couches minces sous vide. Ainsi, pour un filtre dont la bande passante est centrée sur une longueur d'onde centrale λ, le premier miroir consiste en m alternances de couches d'épaisseur optique λ/4 d'un matériau haut indice H et d'un matériau bas indice B. Ce miroir peut également être une couche mince métallique semi-réfléchissante. La membrane d'espacement consiste fréquemment en 2 couches du matériau bas indice B d'épaisseur optique λ/4. En général le second miroir est symétrique du premier. La modification de l'épaisseur géométrique de la membrane d'espacement permet d'accorder le filtre à la longueur d'onde centrale pour laquelle l'épaisseur optique vaut un multiple de λ/2.

Une technique connue s'appuie sur un module de filtrage comportant un filtre par bande à analyser. Si le nombre de bandes vaut n, la réalisation de n filtres passe donc par n fabrications distinctes en dépôt sous vide. Le coût est ainsi très important (et quasi-proportionnel au nombre n de bandes) pour les petites séries et ne devient réellement intéressant que pour des séries suffisamment importantes. De plus, ici aussi les possibilités de miniaturisation sont très limitées et il est difficilement envisageable de prévoir un grand nombre de filtres.

Une alternative développée plus récemment met en œuvre un module de filtrage du type Fabry-Pérot, les deux miroirs n'étant plus parallèles mais agencés en forme de coin pour ce qui concerne le profil dans un plan perpendiculaire au substrat. Dans ce plan repéré Oxy, les axes Ox et Oy étant respectivement colinéaire et perpendiculaire au substrat, l'épaisseur selon Oy de la membrane d'espacement varie linéairement en fonction de la position selon Ox où elle est mesurée.

Le document US 2006 / 0209413 enseigne un dispositif de spectroscopie en longueur d'onde comportant un tel module de filtrage. Il s'ensuit que la longueur d'onde d'accord varie ici de manière continue selon l'axe Ox.

Ces différentes technologies permettent d'analyser un objet avec une résolution spectrale satisfaisante lorsque l'on recherche un spectre continu.

Elles sont également bien adaptées dans le cas où un nombre fini de bandes passantes relativement fines (c'est-à-dire un spectre discret par opposition à un spectre continu) est suffisant pour identifier les constituants recherchés.

Toutefois, elles considèrent l'objet à analyser comme une entité indissociable, c'est-à-dire non résolu spatialement, et elles ne sont pas aptes à identifier des variations de transmission ou de réflexion optique au sein même de l'objet.

Ainsi, le document FR 2 904 432 enseigne une structure matricielle de filtrage optique et un capteur d'images associé. Il s'agit ici de parvenir à l'obtention des différentes couleurs. En effet, à partir de trois couleurs fondamentales prélevées dans le spectre visible (rouge, vert, bleu), on peut reconstituer la majorité des couleurs.

Dans le cas présent, on utilise une matrice de filtres disposée à la surface d'une matrice de détecteurs. La matrice de filtres est ici une matrice dite de « Bayer » mais cela importe peu pour la présente invention. La matrice de détecteurs est une matrice dite APS CMOS (« Active Pixel Sensor Complementary Metal Oxide Semiconductor » en terminologie anglaise). Cette matrice est implémentée sur un substrat semiconducteur à la surface duquel sont agencés des zones photosensibles, des circuits électroniques et des connexions électriques.

Sur un pixel élémentaire, la zone photosensible ne représente qu'une partie de la surface totale, le reste de la surface étant occupée par l'électronique de commande. Il faut donc prévoir des microlentilles, une par pixel, pour focaliser la lumière incidente sur la zone photosensible du pixel. La matrice de filtres est agencée au contact du détecteur si bien que l'ensemble se présente comme un composant consistant en un empilement détecteurs-filtres-microlentilles .

En effet, il n'est pas envisageable de déposer la matrice de filtres sur les microlentilles car la topologie de ces derniers est très marquée. De plus, les microlentilles sont en résine si bien qu'il semble délicat de réaliser un filtre inorganique sur un matériau organique.

Or l'ouverture angulaire du faisceau incident sur les filtres est importante quand ces derniers sont disposés sous les microlentilles. La réponse des filtres est très liée à cet angle d'incidence. Il s'ensuit une modification de la réponse spectrale.

A ce sujet, le document US 2014/0268146 enseigne un réseau de microlentilles avec filtres passe-bande intégrés auquel un détecteur est adjoint. Par ailleurs, il y a un déflecteur entre le réseau de microlentilles et le détecteur.

Pour éviter ce problème d'incidence angulaire sur les filtres on pourrait envisager de supprimer les microlentilles. Toutefois, la zone photosensible présente une surface réduite par référence à la surface totale du pixel. Le gain en sensibilité apporté par la microlentille est d'environ 50%. Il semble donc inapproprié de perdre en sensibilité en supprimant les microlentilles.

Il faut par ailleurs mentionner que le rendement de fabrication d'un tel composant est relativement faible. Le rendement global est sensiblement égal au produit des trois rendements suivants :
- fabrication du détecteur,
- fabrication de la matrice de filtres,
- fabrication du réseau de microlentilles.

Il s'ensuit qu'en multipliant les opérations de fabrication, on réduit le rendement global en conséquence.

Ainsi le document WO2017/187029 a pour objet un dispositif d'imagerie multispectrale qui ne présente pas les limitations évoquées ci-dessus.

Ce dispositif d'imagerie multispectrale comporte :
- un détecteur photosensible formé d'une matrice de pixels,
- un réseau de microlentilles répliquant cette matrice de pixels,
- un module de filtrage formé d'une matrice de filtres élémentaires répliquant cette matrice de pixels,
- le réseau de microlentilles étant agencé directement au contact du détecteur, et
- le module de filtrage étant réalisé sur un substrat qui est rapporté au contact du réseau de microlentilles.

Le problème de ce détecteur est qu'il est réalisé en technologie CMOS (Silicium) et donc qu'il ne vise que les spectres visible et proche infrarouge soit grossièrement de 400 à 1 000 nanomètres.

Pour étendre le spectre du côté de l'infrarouge on a maintenant coutume de recourir à un détecteur en InGaAs. On peut donc atteindre 2 500 nanomètres.

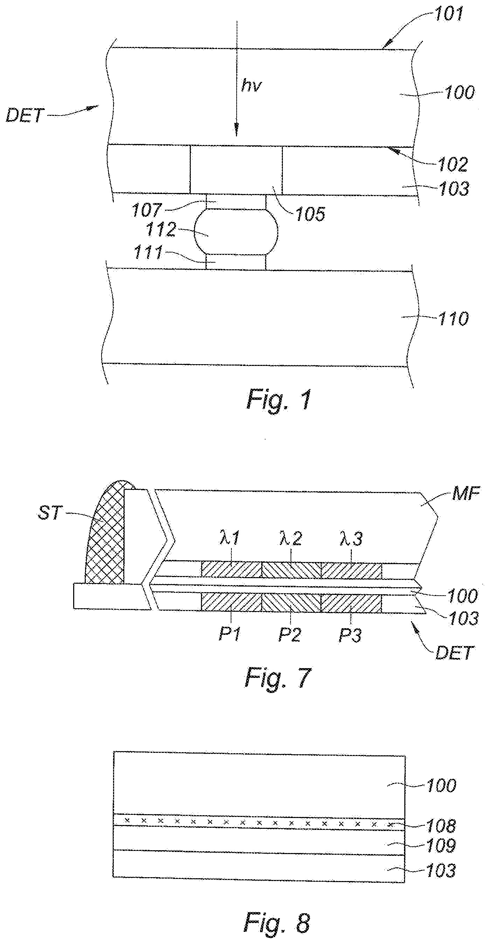

En référence à la figure 1, ce détecteur DET est ainsi composé en partant de la face arrière sur laquelle a lieu l'illumination.

Un substrat 100, par exemple en InP d'une épaisseur de l'ordre de 300 µm, présente une face arrière 101 qui est illuminée par un rayonnement incident. Sur la face avant 102 de ce substrat figure une structure épitaxiée 103 à base d'InGaAs photosensible sur laquelle figure une pluralité de pixels dont un seul 105 est représenté dans son intégralité. Sur ce pixel 105 figure un premier plot métallique 107 destiné à collecter les électrons qui ont été générés en son sein. Le plot 107 est représenté à cet endroit pour la compréhension de la figure au niveau du pixel, mais il peut également être positionné ailleurs, les charges générées au sein du pixel étant routées jusqu'à lui par l'intermédiaire de pistes métalliques.

Le pixel 105 est lu par un circuit de lecture 110 implémenté sur un substrat de silicium. Ainsi, sur ce dernier substrat figure un deuxième plot métallique 111 qui est connecté par un « bump » 112, boule de soudure, au premier plot métallique 107.

On pourrait donc théoriquement rapporter un module de filtrage au contact du substrat en InP. Or il s'avère qu'un tel dispositif ne fonctionne pas. En effet, la taille d'un pixel étant typiquement de l'ordre de 10 µm et la distance introduite par l'épaisseur du substrat en InP étant typiquement de l'ordre de 300 µm, la diaphonie est si forte qu'elle empêche l'obtention de signaux de mesure exploitables à partir des pixels.

La présente invention a ainsi pour objet un capteur d'imagerie multispectrale hybride qui fonctionne pour des longueurs d'onde supérieures à 1 000 nm et allant jusqu'à 2 200 nm.

Selon l'invention, un capteur d'imagerie multispectrale infrarouge comporte :
- un détecteur photosensible à illumination face arrière réalisé sur un premier substrat en InP ayant une face arrière et une face avant et qui est formé d'une matrice de pixels eux-mêmes réalisés dans une structure à base d'InGaAs déposée par épitaxie sur la face avant du premier substrat en InP, et
- un module de filtrage formé d'une matrice de filtres élémentaires répliquant cette matrice de pixels, constitué par un empilement d'un premier miroir et d'un deuxième miroir séparés par une membrane d'espacement, ce module de filtrage définissant une pluralité de cellules de filtrage comportant chacune au moins deux filtres, dans lequel ledit module de filtrage est formé sur un deuxième substrat sur lequel le premier miroir, la membrane d'espacement et le deuxième miroir ont été déposés dans cet ordre ;
- le deuxième miroir est rapporté au contact dudit premier substrat, formant ainsi un capteur d'imagerie multispectrale hybride qui fonctionne pour des longueurs d'onde supérieures à 1 000 nm et allant jusqu'à 2 200 nm; et ;
- ledit premier substrat en InP présente
- une épaisseur inférieure à 50 µm, préférentiellement inférieure à 30 µm, et encore plus préférentiellement inférieure à 10 µm.

On minimise ainsi considérablement les phénomènes de diaphonie.

Un article de Bora M. Onat titré « A Solid-State Hyperspectral Imager for Real-time Standoff Explosives Détection using Shortwave Infrared Imaging », publié dans Non-Intrusive Inspection Technologies II édité par Brandon W. Blackburn, Proc. Of SPIE Vol. 7310, 731004, divulgue un système d'imagerie multispectrale fonctionnant dans l'infrarouge.

Un article scientifique de Heng-jing Tang titré « The novel dual-waveband SWIR InGaAs FPAs with monolithic intégration filter microstructure » publié dans Optical Components and Materials, actes de Spie Vol. 8982, décrit un détecteur optique basé sur des photodiodes formées dans une couche de InGaAs déposée par épitaxie sur un substrat en InP et incluant des cavités Fabry-Pérot formées dans des couches déposées par évaporation sur ce même substrat en InP. Toutefois ce capteur est obtenu par intégration monolithique.

Le document de brevet US 2003/0006416 A1 divulgue une méthode d'intégration d'une puce électronique avec une puce optiquement active en face arrière.

Un article de Wang Xu-quan titré « Integrated Linear Variable Filter / InGaAs Focal Plane Array Spectral Micro-module and its Wavelength Calibration » publié dans Acta Photonica Sinica, Vol. 47 N°.5, May 2018, divulgue un module intégré avec un filtre linéaire variable et une matrice de détection InGaAs.

Un article de Tara Martin intitulé « 640x512 InGaAs focal plane array camera for visible and SWIR imaging », publié dans Proc. Of SPIE Vol. 5783 pp 13-20, divulgue une matrice de détection InGaAs.

Un article de Marshall J. Cohen intitulé « A Thin Film Indium Gallium Arsenide Focal Plane Array for Visible and Near Infrared Hyperspectral Imaging", publié dans 1999 IEEE Leos Annual Meeting Conférence Proceedings, IEEE Laser and Electro-Optics Society, Vol. 2, 8 november 1999, divulgue une structure hétéroepitaxiale avec une couche active d'InGaAs et une cathode d'InP sous celle-ci.

Avantageusement, le module de filtrage du capteur selon l'invention est collé sur son pourtour à ce détecteur.

De préférence, le module de filtrage est pourvu de motifs d'alignement.

En particulier, le module de filtrage d'une part et le détecteur photosensible réalisé sur le substrat en InP d'autre part sont fabriqués indépendamment au cours de procédés de fabrication parallèles de manière à former deux éléments séparés, puis le module de filtrage est rapporté au contact du substrat en InP et fixé à ce dernier par un moyen de fixation tel que de la colle, de sorte que l'on obtient un structure hybride comprenant le module de filtrage, le substrat en InP et le détecteur photosensible, dans cet ordre.

Ainsi, le capteur d'imagerie selon l'invention fonctionne comme un capteur face arrière, c'est-à-dire qu'un rayonnement à détecter traverse le substrat InP du détecteur photosensible avant d'irradier ce dernier.Par exemple, le module de filtrage étant constitué de deux miroirs séparés par une membrane d'espacement, ce module de filtrage comportant une pluralité de cellules de filtrage, ces cellules de filtrage comportent chacune au moins deux filtres.

Ainsi, l'un au moins de ces filtres a une fonction de transfert passe-bande.

Suivant une caractéristique additionnelle, certaines au moins de ces cellules de filtrage sont alignées dans un premier ruban.

De même, certaines au moins de ces cellules de filtrage sont alignées dans un second ruban parallèle au et disjoint du premier ruban.

Suivant un mode de réalisation privilégié, deux au moins de ces filtres qui sont adjacents sont séparés par une barrière de diaphonie.

Eventuellement, l'un au moins de ces filtres est panchromatique. Normalement, le détecteur est rapporté sur un circuit de lecture. Avantageusement, le circuit de lecture est intégré en technologie CMOS. Selon une première option, le substrat en InP est affiné par polissage. Selon une deuxième option, le substrat en InP est affiné par gravure.

La présente invention apparaîtra maintenant avec plus de détails dans le cadre de la description qui suit d'exemples de réalisation donnés à titre illustratif en se référant aux figures annexées qui représentent :
- la figure 1, le schéma connu d'un détecteur réalisé sur un substrat en InP,
- la figure 2, le schéma de principe d'une cellule de filtrage à une dimension, plus particulièrement :
   - la figure 2a, une vue de dessus de cette cellule, et
   - la figure 2b, une vue en coupe de cette cellule ;
- les figures 3a à 3c, trois étapes d'un mode de réalisation d'un module de filtrage ;
- la figure 4, le schéma de principe d'un module de filtrage à deux dimensions ;
- la figure 5, un schéma d'un module de filtrage à 64 filtres muni d'un quadrillage d'écrantage ;
- la figure 6, le schéma d'un module de filtrage dont les cellules comportent chacune neuf filtres ;
- la figure 7, un schéma en coupe d'un dispositif selon l'invention ;
- la figure 8, une représentation d'un dispositif destiné à former un détecteur.

Les éléments présents dans plusieurs figures sont affectés d'une seule et même référence.

On commence par décrire le module de filtrage qui comporte une pluralité de cellules de filtrage généralement identiques formées sur un substrat SUB.

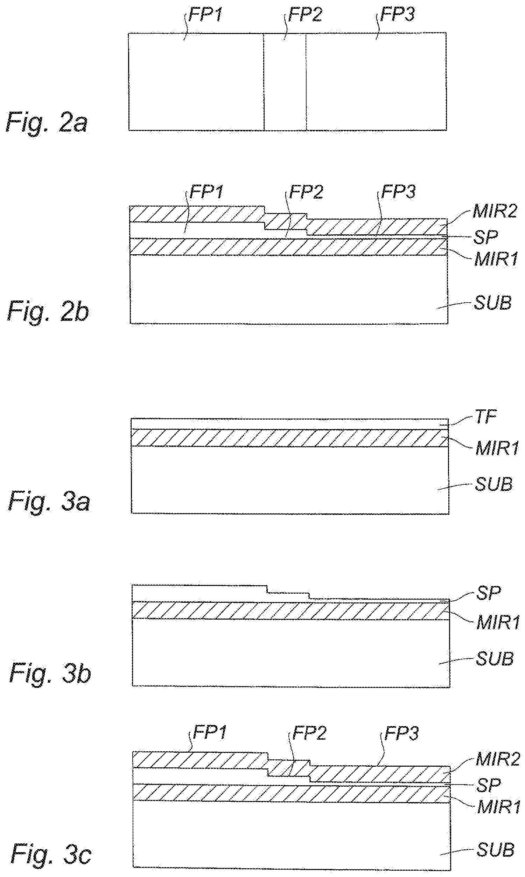

En référence aux figures 2a et 2b, une cellule de filtrage comporte trois filtres interférentiels du type Fabry-Pérot FP1, FP2, FP3 alignés successivement de sorte qu'ils forment un ruban.

Cette cellule est constituée par l'empilement sur ledit substrat SUB du module de filtrage, en verre, en silice ou en silicium par exemple, d'un premier miroir MIR1, d'une membrane d'espacement SP et d'un deuxième miroir MIR2.

La membrane d'espacement SP qui définit la longueur d'onde centrale de chaque filtre est donc constante pour un filtre donné et varie d'un filtre à l'autre. Son profil a une forme d'escalier car chaque filtre a une surface sensiblement rectangulaire.

Un procédé avantageux de réalisation du module de filtrage en technologie couches minces est donné à titre d'exemple.

En référence à la figure 3a, on commence par déposer sur le substrat SUB le premier miroir MIR1 puis une couche ou un ensemble de couches diélectriques TF appelé à définir la membrane d'espacement SP. Le miroir est soit métallique soit diélectrique.

En référence à la figure 3b, ce diélectrique TF est gravé :
- dans un premier temps au niveau des deuxième FP2 et troisième FP3 filtres pour définir l'épaisseur de la membrane d'espacement SP au niveau du 2^{ème} filtre FP2,
- dans un deuxième temps au niveau du troisième filtre FP3 pour définir à son niveau l'épaisseur de cette membrane.

La membrane d'espacement SP au niveau du premier filtre FP1 a l'épaisseur du dépôt.

En référence à la figure 3c, le deuxième miroir MIR2 est déposé sur la membrane d'espacement SP pour finaliser les trois filtres.

La membrane d'espacement SP peut être obtenue par dépôt d'un diélectrique TF puis gravures successives comme présenté ci-dessus mais elle peut également être obtenue par plusieurs dépôts successifs de couches minces.

A titre d'exemple, on peut balayer la plage de longueurs d'onde de 900 à 2 000 nm en modifiant l'épaisseur optique de la membrane d'espacement.

Il convient ici de noter que l'épaisseur de la membrane d'espacement doit être suffisamment faible pour n'obtenir qu'une bande de transmission dans le domaine à sonder. En effet, plus on augmente cette épaisseur, plus le nombre de longueurs d'onde satisfaisant la condition [ne = k λ/2] augmente.

L'invention permet donc de réaliser un ensemble de filtres alignés, ces filtres pouvant ainsi être référencés dans un espace à une dimension.

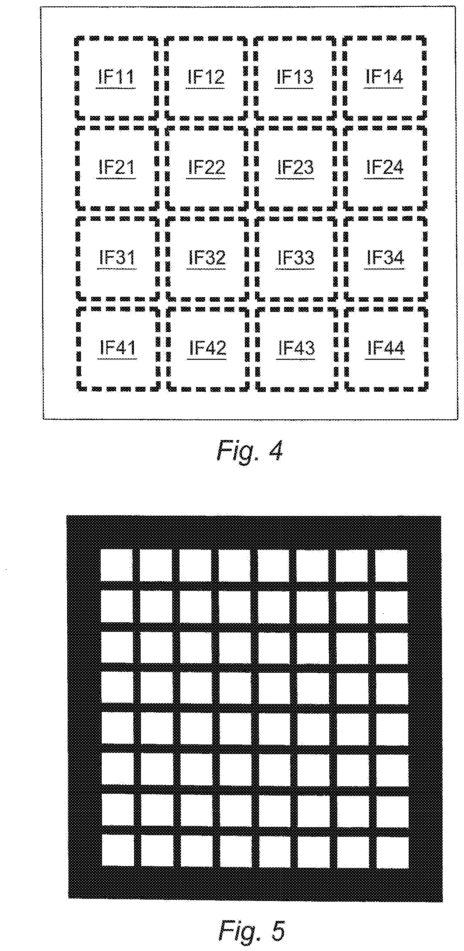

En référence à la figure 4, l'invention permet également d'organiser les cellules de filtrage dans un espace à deux dimensions. Une telle organisation est souvent dénommée matricielle.

Quatre rubans horizontaux identiques comprennent chacun quatre cellules. Le premier ruban, celui qui apparaît en haut de la figure, correspond à la première ligne d'une matrice et comprend les cellules IF11 à IF14. Le deuxième, le troisième, respectivement le quatrième ruban comprend les cellules IF21 à IF24, les filtres IF31 à IF34, respectivement les cellules IF41 à IF44.

L'organisation est dite matricielle car la cellule IFjk appartient au jème ruban horizontal et également à un kième ruban vertical qui comprend les cellules IF1k, IF2k, ..., IF4k.

En référence à la figure 5, il est souhaitable de bien séparer les différents filtres du module de filtrage afin d'éviter un recouvrement partiel d'un filtre sur un filtre qui lui est adjacent et de minimiser un éventuel problème de diaphonie. Pour ce faire, on peut ajouter sur le module de filtrage un quadrillage (en noir sur la figure) constituant une barrière de diaphonie pour délimiter tous les filtres. Ce quadrillage sera absorbant. A titre d'exemple, un quadrillage absorbant peut être réalisé par dépôt et gravure d'un chrome noir (chrome + oxyde de chrome) tandis qu'un quadrillage réfléchissant peut être réalisé par dépôt et gravure de chrome.

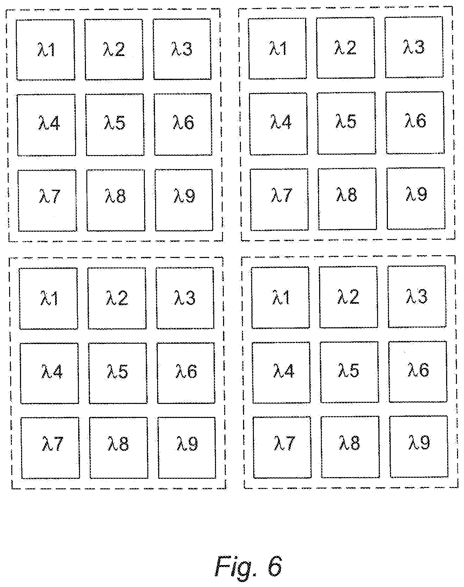

En référence à la figure 6, chaque cellule de filtrage comporte dorénavant 9 filtres. Ces cellules se présentent chacune comme un carré dans lequel s'inscrit chaque filtre accordé sur une longueur d'onde distincte λ1, λ2, A3, λ4, ..., λ9.

Sur cette figure, pour des raisons de clarté, l'espacement entre les cellules a été volontairement augmenté par rapport à l'espacement entre deux filtres. Dans la réalité, bien entendu, ces espacements sont identiques.

Le module de filtrage est donc associé à un détecteur à même de mesurer les flux lumineux produits par les différents filtres.

En référence à la figure 7, on reprend le module de filtrage MF qui est présenté à la figure 6.

Le détecteur DET est réalisé en technologie InGaAs sur un substrat InP comme décrit dans l'introduction de la présente demande.

Le module de filtrage MF vient en appui sur le détecteur DET au contact substrat en InP de sorte que les filtres λ1, λ2, λ3 soient en regard des pixels P1, P2, P3 et interposés entre le substrat en InP du détecteur DET et le substrat SUB du module de filtrage.

De cette manière, la distance séparant les pixels des filtres est minimisée, pouvant être réduite jusqu'à l'épaisseur du substrat en InP, et la diaphonie est elle aussi minimisée.

Le positionnement de ce module MF se fait au moyen de motifs d'alignement, technique connu en photolithographie par l'homme du métier qui ne sera donc pas plus développée.

Le module de filtrage MF est fixé sur le détecteur DET au moyen d'un liseré de colle ST.

En particulier, le module de filtrage MF est réalisé sur un premier type de substrat, verre, silice ou silicium par exemple, et le détecteur DET est réalisé sur un deuxième type de substrat, de l'InP ici, ces deux éléments assemblés l'un à l'autre formant la structure hybride du capteur d'imagerie.

Pour fixer les idées, on précisera que les pixels ont couramment une taille de l'ordre de 15 microns.

Par ailleurs on a bien compris qu'il convenait d'affiner le substrat 100 en InP. Pour ce faire on propose deux solutions.

La première solution consiste à polir le substrat mécaniquement jusqu'à ce qu'il atteigne une épaisseur de l'ordre de 20 à 30 microns.

Selon la deuxième solution, en référence à la figure 8, sur le substrat 100 en InP on fait croître une couche d'arrêt 108 puis on réalise une couche mince 109 d'InP par épitaxie.

Sur cette couche mince 109 on procède maintenant à la croissance de la couche active 103 en InGaAs.

Il convient donc de graver le substrat 100 jusqu'à la couche d'arrêt 108 en gravure sélective puis de graver cette couche d'arrêt à nouveau en gravure sélective. On obtient de la sorte l'épaisseur requise du support 109 en InP.

Les exemples de réalisation de l'invention présentés ci-dessus ont été choisis eu égard à leur caractère concret. Il ne serait cependant pas possible de répertorier de manière exhaustive tous les modes de réalisation que recouvre cette invention. En particulier, tout moyen décrit peut être remplacé par un moyen équivalent sans sortir du cadre de la présente invention; l'invention étant définie par les revendications annexées.

## Revendications

1. Capteur d'imagerie multispectrale infrarouge comportant :
- un détecteur (DET) photosensible à illumination face arrière réalisé sur un premier substrat (100) en InP ayant une face arrière (101) et une face avant (102) et qui est formé d'une matrice de pixels (105, P1, P2, P3) eux-mêmes réalisés dans une structure à base d'InGaAs (103) déposée par épitaxie sur la face avant du premier substrat (100) en InP, et
- un module de filtrage (MF) formé d'une matrice de filtres élémentaires (λ1, λ2, λ3) répliquant cette matrice de pixels, constitué par un empilement d'un premier miroir (MIR1) et d'un deuxième miroir (MIR2) séparés par une membrane d'espacement (SP), ce module de filtrage définissant une pluralité de cellules de filtrage (IF11, IF12, ... , IF44) comportant chacune au moins deux filtres (FP1, FP2, FP3), **caractérisé en ce que**
- ledit module de filtrage (MF) est formé sur un deuxième substrat (SUB) sur lequel le premier miroir (MIR1), la membrane d'espacement (SP) et le deuxième miroir (MIR2) ont été déposés dans cet ordre ;
- le deuxième miroir (MIR2) est rapporté au contact dudit premier substrat (100), formant ainsi un capteur d'imagerie multispectrale hybride qui fonctionne pour des longueurs d'onde supérieures à 1 000 nm et allant jusqu'à 2 200 nm; et
- ledit premier substrat (100) en InP présentant une épaisseur inférieure à 50 µm, de préférence inférieure à 30 µm.

2. Capteur selon la revendication 1, **caractérisé en ce que** ledit module de filtrage (MF) est collé sur son pourtour audit détecteur (DET).

3. Capteur selon l'une quelconque des revendications 1 ou 2, **caractérisé en ce que** ledit module de filtrage (MF) est pourvu de motifs d'alignement.

4. Capteur selon la revendication 3, **caractérisé en ce que** l'un au moins desdits filtres (FP1, FP2, FP3) a une fonction de transfert passe-bande.

5. Capteur selon la revendication 4, **caractérisé en ce que** certaines au moins desdites cellules de filtrage (IF11, IF12, IF13, IF14) sont alignés dans un premier ruban.

6. Capteur selon la revendication 5, **caractérisé en ce que** certaines au moins desdites cellules de filtrage (IF21-IF24) sont alignés dans un second ruban parallèle au et disjoint du premier ruban.

7. Capteur selon l'une quelconque des revendications 4 à 6, **caractérisé en ce que** deux au moins desdits filtres (FP1, FP2, FP3) qui sont adjacents sont séparés par une barrière de diaphonie.

8. Capteur selon l'une quelconque des revendications 4 à 7, **caractérisé en ce que** l'un au moins desdits filtres (FP1, FP2, FP3) est panchromatique.

9. Capteur selon l'une quelconque des revendications précédentes, **caractérisé en ce que** ledit détecteur (DET) est rapporté sur un circuit de lecture (110).

10. Capteur selon la revendication 9, **caractérisé en ce que** ledit circuit de lecture (110) est intégré en technologie CMOS.

11. Capteur selon l'une quelconque des revendications précédentes, **caractérisé en ce que** ledit substrat (100) en InP est affiné par polissage.

12. Capteur selon l'une quelconque des revendications 1 à 10, **caractérisé en ce que** ledit substrat (100) en InP est affiné par gravure.

## Patentansprüche

1. Multispektraler Infrarot-Bildsensor, umfassend:
- einen lichtempfindlichen Detektor (DET) mit rückseitiger Beleuchtung, der auf einem ersten InP-Substrat (100) mit einer Rückseite (101) und einer Vorderseite (102) ausgeführt und aus einer Matrix aus Pixeln (105, P1, P2, P3) ausgebildet ist, die selbst in einer auf InGaAs (103) basierenden Struktur ausgeführt sind, die auf der Vorderseite des ersten InP-Substrats (100) mittels Epitaxie abgesetzt ist, und
- ein aus einer Matrix von diese Pixelmatrix replizierenden Elementarfiltern (λ1, λ2, λ3) ausgebildetes Filtermodul (MF), das aus einem Stapel eines ersten Spiegels (MIR1) und eines zweiten Spiegels (MIR2) besteht, die durch eine Abstandsmembran (SP) voneinander getrennt sind, wobei dieses Filtermodul mehrere Filterzellen (IF11, IF12,..., IF44) definiert, die jeweils mindestens zwei Filter (FP1, FP2, FP3) umfassen, **dadurch gekennzeichnet, dass**
- das Filtermodul (MF) auf einem zweiten Substrat (SUB) ausgebildet ist, auf dem der erste Spiegel (MIR1), die Abstandsmembran (SP) und der zweite Spiegel (MIR2) in dieser Reihenfolge abgesetzt wurden;
- der zweite Spiegel (MIR2) mit dem ersten Substrat (100) derart in Kontakt gebracht ist, dass ein hybrider multispektraler Bildsensor ausgebildet wird, der bei Wellenlängen über 1000 nm und bis zu 2200 nm arbeitet; und
- das erste InP-Substrat (100) eine Dicke von weniger als 50 µm, vorzugsweise weniger als 30 µm aufweist.

2. Sensor nach Anspruch 1, **dadurch gekennzeichnet, dass** das Filtermodul (MF) an seinem Umfang an den Detektor (DET) geklebt ist.

3. Sensor nach einem der Ansprüche 1 oder 2, **dadurch gekennzeichnet, dass** das Filtermodul (MF) mit Ausrichtungsmarkierungen versehen ist.

4. Sensor nach Anspruch 3, **dadurch gekennzeichnet, dass** der mindestens eine Filter (FP1, FP2, FP3) eine Bandpass-Übertragungsfunktion hat.

5. Sensor nach Anspruch 4, **dadurch gekennzeichnet, dass** zumindest einige der Filterzellen (IF11, IF12, IF13, IF14) in einem ersten Streifen ausgerichtet sind.

6. Sensor nach Anspruch 5, **dadurch gekennzeichnet, dass** zumindest einige der Filterzellen (IF21-IF24) in einem zu dem ersten Streifen parallelen und nicht mit diesem verbundenen, zweiten Streifen ausgerichtet sind.

7. Sensor nach einem der Ansprüche 4 bis 6, **dadurch gekennzeichnet, dass** mindestens zwei der Filter (FP1, FP2, FP3), die zueinander benachbart sind, durch eine Übersprechsperre getrennt sind.

8. Sensor nach einem der Ansprüche 4 bis 7, **dadurch gekennzeichnet, dass** der mindestens eine Filter (FP1, FP2, FP3) panchromatisch ist.

9. Sensor nach einem der vorhergehenden Ansprüche, **dadurch gekennzeichnet, dass** der Detektor (DET) auf einer Leseschaltung (110) angebracht ist.

10. Sensor nach Anspruch 9, **dadurch gekennzeichnet, dass** die Ausleseschaltung (110) in CMOS-Technologie integriert ist.

11. Sensor nach einem der vorhergehenden Ansprüche, **dadurch gekennzeichnet, dass** das InP-Substrat (100) durch Polieren vorbereitet ist.

12. Sensor nach einem der Ansprüche 1 bis 10, **dadurch gekennzeichnet, dass** das InP-Substrat (100) durch Ätzen vorbereitet ist.

## Claims

1. An infrared multispectral imaging sensor comprising:
- a photosensitive back-side-illumination detector (DET) which is produced on a first substrate (100) made of InP and having a back side (101) and a front side (102), and which is formed of a matrix of pixels (105, P1, P2, P3) themselves produced in an InGaAs-based structure (103) deposited by epitaxy on the front side of the first substrate (100) made of InP, and
- a filtering module (MF) which is formed of a matrix of elementary filters (λ1, λ2, λ3) replicating said matrix of pixels, and which is made up of a stack of a first mirror (MIR1) and a second mirror (MIR2) separated by a spacer membrane (SP), said filtering module defining a plurality of filtering cells (IF11, IF12, ..., IF44) each comprising at least two filters (FP1, FP2, FP3), **characterized in that**
- said filtering module (MF) is formed on a second substrate (SUB) on which the first mirror (MIR1), the spacer membrane (SP), and the second mirror (MIR2) have been deposited **in that** order;
- the second mirror (MIR2) is placed in contact with said first substrate (100), thus forming a hybrid multispectral imaging sensor which functions for wavelengths greater than 1000 nm and ranging up to 2200 nm; and
- said first substrate (100) made of InP having a thickness of less than 50 µm, preferably less than 30 µm.

2. The sensor according to claim 1, **characterized in that** said filtering module (MF) is adhesively bonded on its periphery to said detector (DET).

3. The sensor according to either claim 1 or claim 2, **characterized in that** said filtering module (MF) is provided with alignment patterns.

4. The sensor according to claim 3, **characterized in that** at least one of said filters (FP1, FP2, FP3) has a band-pass transfer function.

5. The sensor according to claim 4, **characterized in that** at least some of said filtering cells (IF11, IF12, IF13, IF14) are aligned in a first strip.

6. The sensor according to claim 5, **characterized in that** at least some of the said filtering cells (IF21-IF24) are aligned in a second strip parallel to and separate from the first strip.

7. The sensor according to any of claims 4 to 6, **characterized in that** at least two of said filters (FP1, FP2, FP3) which are adjacent are separated by a crosstalk barrier.

8. The sensor according to any of claims 4 to 7, **characterized in that** at least one of the said filters (FP1, FP2, FP3) is panchromatic.

9. The sensor according to any of the preceding claims, **characterized in that** said detector (DET) is attached to a read circuit (110).

10. The sensor according to claim 9, **characterized in that** said read circuit (110) is integrated using CMOS technology.

11. The sensor according to any of the preceding claims, **characterized in that** said substrate (100) made of InP is refined by polishing.

12. The sensor according to any of claims 1 to 10, **characterized in that** said substrate (100) made of InP is refined by etching.
